(19)

Europäisches
Patentamt
European
Patent Office
Office européen
des brevets

(11) **EP 2 857 561 A1**

(12) **EUROPEAN PATENT APPLICATION**
published in accordance with Art. 153(4) EPC

(43) Date of publication:
**08.04.2015 Bulletin 2015/15**

(21) Application number: **13796752.7**

(22) Date of filing: **23.05.2013**

(51) Int Cl.:
***C30B 29/20*** (2006.01)   ***C30B 15/02*** (2006.01)

(86) International application number:
**PCT/JP2013/064966**

(87) International publication number:
**WO 2013/180195 (05.12.2013 Gazette 2013/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority:  **28.05.2012   JP 2012121027**

(71) Applicant: **Sumitomo Chemical Company, Limited
Tokyo 104-8260 (JP)**

(72) Inventors:
• **OZAKI, Hirotaka**
  **Niihama-shi**
  **Ehime 792-8521 (JP)**
• **FUKUDA, Tsuguo**
  **Sendai-shi**
  **Miyagi 989-3204 (JP)**

(74) Representative: **Vossius & Partner**
   **Siebertstrasse 3**
   **81675 München (DE)**

(54) **STARTING MATERIAL ALUMINA FOR PRODUCTION OF SAPPHIRE SINGLE CRYSTAL AND METHOD FOR PRODUCING SAPPHIRE SINGLE CRYSTAL**

(57)   Disclosed is an alumina raw material for the production of a sapphire single crystal, which contains at least one element X selected from the group consisting of elements (1) to (3) shown below, wherein the concentration of the element X is 10 ppm or more and 1,000 ppm or less expressed in terms of atoms, and each concentration of silicon (Si), gallium (Ga), germanium (Ge) and tin (Sn) is 10 ppm or less expressed in terms of atoms.
Element X:
(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5.

EP 2 857 561 A1

**Description**

Technical Field

The present invention relates to an alumina raw material for the production of a sapphire single crystal, and a method for producing a sapphire single crystal.

Background Art

A compound semiconductor is a semiconductor obtained by bonding two or more atoms through ionic bonding, and is composed of a combination of group III and group V elements, a combination of group II and group VI elements, and the like. A layer of such compound semiconductor is formed on a substrate made of a sapphire single crystal (hereinafter also referred to as a sapphire substrate) and electrodes are formed thereon, followed by grinding, polishing and cutting to obtain a semiconductor device such as a light emitting device.

The sapphire substrate can be obtained, for example, by cutting a single crystal ingot, which is produced by a Czochraski method (CZ method) capable of growing a sapphire single crystal from an alumina melt, into a desired thickness.

In order to grow a compound semiconductor layer on a c-plane ((0001) plane) of a sapphire single crystal, such sapphire substrate requires a c-plane. When the sapphire single crystal is pulled up in a c-axis direction, a c-plane substrate can be obtained by slicing along a plane perpendicular to a c-axis. However, pulling in the c-axis direction has a problem that foaming is likely to occur and the crystal causes abnormal growth.

Since the Czochraski method is likely to be influenced by the production conditions, a slight change in the production conditions is likely to cause crystal defects and distortion in the obtained sapphire single crystal, thus requiring precise control of ingot pulling conditions, temperature conditions, and the like. Therefore, in the case of forming a sapphire single crystal ingot having a large diameter which is the recent main stream, it is considered to be difficult to form a crystal having less crystal defects and less distortion over the entire ingot.

Patent Document 1 discloses a method in which a melt is prepared from aluminum oxide, and an oxide of at least one element of silicon (Si), germanium (Ge) and tin (Sn) in a prescribed amount based on the aluminum oxide, and then a sapphire single crystal ingot is obtained by a Czochraski method using this melt.

According to this method, Si, Ge, and Sn belonging to the same group as that of aluminum in the Periodic Table are intentionally added to a pure alumina raw material as impurities, thereby intentionally imparting distortion to the crystal thus formed. Thus, the crystal lattice is provided with flexibility, thereby offsetting thermal distortion, leading to an enhancement in crystal quality as a whole. It is considered that the addition of an element having a valence different from that of aluminum serving as a principal constituent element of a sapphire single crystal, to aluminum oxide causes reduction in distortion of the obtained sapphire single crystal. Especially, Si is stable in the form of an oxide and exerts a significant distortion reduction effect on a sapphire single crystal upon addition, thus enabling facilitated crystal growth and satisfactory single crystallization rate.

However, in the method disclosed in Patent Document 1, about several tens of ppms of Si, Ge and Sn as additive elements are incorporated into the obtained sapphire single crystal. Commonly, due to a difference in concentration of an additive element between the upper and lower portions of a crystal pulled by a Czochraski method, there was a problem such as difficulty in uniform control of the concentration of the additive element in a sapphire single crystal ingot.

It is possible to adjust the amount of the additive element to be incorporated into the crystal by the growing conditions such as a rate of the crystal growth, however, there is a limitation on suppression of the amount to be incorporated into the crystal. Too small amount of the additive element to be incorporated makes it impossible to obtain a good-quality sapphire single crystal with less crystal distortion.

In the pulling and growing method of a sapphire single crystal ingot, such as a Czochraski method, when convection occurs in a raw material melt, crystal distortion is likely to occur in the obtained sapphire single crystal ingot. Generally, a high-frequency induction heating apparatus is often used as a heating apparatus in this method, and convection is likely to occur in the high-frequency induction heating apparatus.

Patent Document 1: JP 2012-12242 A

Disclosure of the Invention

Problems to be Solved by the Invention

As mentioned above, the method for producing a sapphire single crystal using a pulling and growing method such as a Czochraski method left room for further improvement.

An object of the present invention is to provide an alumina raw material for the production of a sapphire single crystal and a method for producing a sapphire single crystal, which are suited to obtain a sapphire single crystal ingot with less distortion. According to the present invention, it is possible to provide a sapphire single crystal which has less crystal distortion and contains little impurities.

Means for Solving the Problem

The present invention relates to the following inventions.

<1> An alumina raw material for the production of a sapphire single crystal, which contains:

at least one element X selected from the group consisting of elements (1) to (3) mentioned below, wherein the concentration of the element X is 10 ppm or more and 1,000 ppm or less expressed in terms of atoms, and each concentration of silicon (Si), gallium (Ga), germanium (Ge) and tin (Sn) is 10 ppm or less expressed in terms of atoms.
Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

<2> The alumina raw material according to the above <1>, which contains, as the element X, at least one element selected from the group consisting of boron (B), selenium (Se), zirconium (Zr) and tantalum (Ta).
<3> The alumina raw material according to the above <1> or <2>, wherein the concentration of alumina is 99.99% by weight or more in components excluding the element X, silicon (Si), gallium (Ga), germanium (Ge) and tin (Sn).
<4> The alumina raw material according to any one of the above <1> to <3>, wherein a specific surface area is 0.1 $m^2$/g or more and 2.0 $m^2$/g or less, a relative density is 80% or more and 95% or less, a closed porosity is 4% or less, and an untamped density (loose bulk density) is 1.0 g/$cm^3$ or more.
<5> A method for producing a sapphire single crystal, which includes the steps of:

charging the alumina raw material according to any one of the above <1> to <4> in a crucible disposed in a furnace body and heating to melt the alumina raw material, and
pulling a sapphire single crystal ingot from a melt obtained as a result of melting of the alumina raw material to grow the sapphire single crystal ingot in an inert gas atmosphere.

<6> A method for producing a sapphire single crystal, which includes the steps of:

charging, as raw materials, alumina and a compound containing at least one element X selected from the group consisting of elements (1) to (3) mentioned below in a crucible disposed in a furnace body in the proportion so that the concentration of the element X becomes 10 ppm or more and 1,000 ppm or less expressed in terms of atoms, and each concentration of silicon (Si), gallium (Ga), germanium (Ge), and tin (Sn) becomes 10 ppm or less expressed in terms of atoms, the concentration being based on alumina, and heating to melt the raw materials, and
pulling a sapphire single crystal ingot from a melt obtained as a result of melting of the raw materials to grow the sapphire single crystal ingot in an inert gas atmosphere. Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

<7> The method for producing a sapphire single crystal according to the above <6>, wherein the element X is at least one element selected from the group consisting of boron (B), selenium (Se), zirconium (Zr) and tantalum (Ta).
<8> The method for producing a sapphire single crystal according to the above <6> or <7>, wherein the concentration of alumina is 99.99% by weight or more.
<9> The method for producing a sapphire single crystal according to any one of the above <5> to <8>, wherein the sapphire single crystal is pulled and grown in a c-axis direction.
<10> A sapphire single crystal produced by the method according to any one of the above <5> to <9>, wherein the concentration of the element X is 5 ppm or less expressed in terms of atoms.

Brief Description of the Drawings

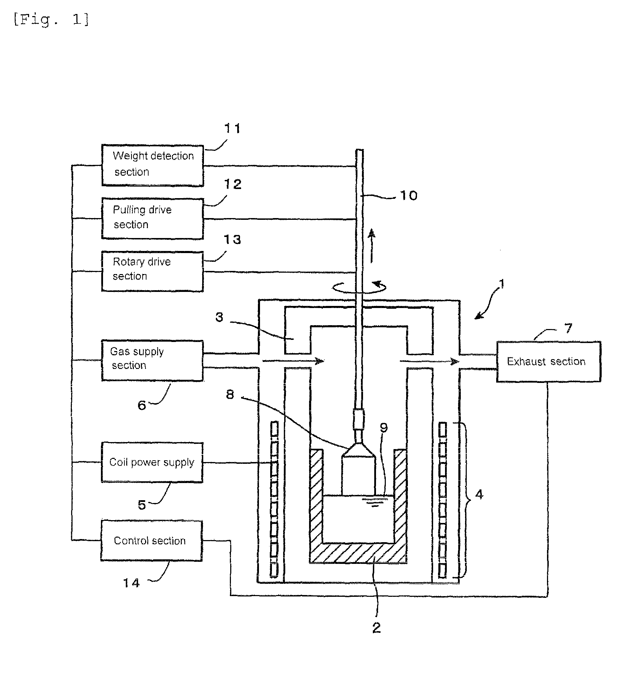

Fig. 1 is a schematic diagram of a single crystal pulling apparatus.

Mode for Carrying Out the Invention

The present invention will be described in detail below by way of example materials, but the present invention is not limited to the following example materials and arbitrary changes can be made without departing from the scope of the present invention.

<1. Alumina Raw Material for Production of Sapphire Single Crystal>

The present invention is directed to an alumina raw material (hereinafter sometimes simply referred to as an "alumina raw material of the present invention") for the production of a sapphire single crystal, which contains at least one element X selected from the group consisting of elements (1) to (3) mentioned below, wherein the concentration of the element X is 10 ppm or more and 1,000 ppm or less expressed in terms of atoms, and each concentration of silicon (Si), gallium (Ga), germanium (Ge), and tin (Sn) is 10 ppm or less expressed in terms of atoms. Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

The alumina raw material of the present invention contains an element X satisfying the above-mentioned ionic radius and valence alone, or two or more the elements X.

The element X may be an element of the above elements (1) to (3), of which the element X is preferably at least one element selected from the group consisting of boron (B), selenium (Se), zirconium (Zr) and tantalum (Ta).

In a conventional method in which Si, Ge, and the like are added as additive elements to a raw material aluminum oxide, disclosed in Patent Document 1, incorporation of these additive elements in a crystal enables an improvement in crystal quality as a whole. Therefore, the obtained sapphire single crystal inevitably contains these additive elements. Accordingly, the concentration of the additive element in a melt during crystal growth changes, which leads to a difference in concentration of an additive element between the upper and lower portions of a sapphire single crystal ingot. As a result, it is difficult to control the concentration of the additive element uniformly in the sapphire single crystal ingot, thus failing to uniformly improve crystal quality.

Meanwhile, use of an alumina raw material of the present invention as a raw material enables little incorporation of the element X into the obtained sapphire single crystal.

Use of the alumina raw material of the present invention as the raw material enables enhancement in crystallinity with hardly any incorporation of the element X into the crystal, thus not causing a problem that crystal quality cannot be uniformly improved.

When using the alumina raw material of the present invention as the raw material, it is usually possible to adjust the concentration of the element X in a sapphire single crystal obtained by a pulling and growing method to 10 ppm or less, and preferably 5 ppm or less, expressed in terms of atoms. In the present invention, a sapphire single crystal containing the element X as an additive element is called a sapphire single crystal, or a sapphire single crystal ingot, as lon as crystallinity is maintained.

The pulling and growing method includes a Czochraski method.

The concentration of the additive element (the concentration of the element X) in the alumina raw material of the present invention, and a sapphire crystal obtained by using the alumina raw material as the raw material is measured by an ICP atomic emission spectroscopy.

The crystal structure of the alumina raw material of the present invention is not particularly limited and may be any crystal structure, for example, $\alpha$ alumina, $\gamma$ alumina, $\theta$ alumina, $\chi$ alumina and the like, of which $\alpha$ alumina is preferable in view of the fact that it has a small BET specific surface area and is capable of suppressing adsorbed moisture.

In the alumina raw material of the present invention, each content of silicon (Si), gallium (Ga), germanium (Ge) and tin (Sn) is 10 ppm or less, and preferably 5 ppm or less, expressed in terms of atoms.

When each content of Si, Ga, Ge, and Sn is more than 10 ppm expressed in terms of atoms, crystallinity of the sapphire single crystal ingot obtained by using the alumina raw material of the present invention as the raw material deteriorates, thus making it impossible to obtain a sapphire single crystal with less distortion.

The content of the element X in the alumina raw material of the present invention is appropriately selected according to the kind of the element X, and is 10 ppm or more and 1,000 ppm or less, and preferably 50 ppm or more and 500 ppm or less, expressed in terms of atoms. When two or more elements X are contained, the content of the element X is sum total of all elements X.

When the content of the element X is too small, addition effect of the element X becomes insufficient, thus making it difficult to obtain a sapphire single crystal ingot with less distortion.

When the content of the element X is too large, crystal quality deteriorates to the contrary, for example, melt viscosity excessively changes, and coloration and foaming occur.

When the alumina raw material of the present invention contains only one element X and the element X is boron (B), the content of the element X is preferably 10 ppm or more and 100 ppm or less expressed in terms of atoms.

When the alumina raw material of the present invention contains only one element X and the element X is selenium (Se), the content of the element X is preferably 100 ppm or more and 1,000 ppm or less expressed in terms of atoms.

When the alumina raw material of the present invention contains only one element X and the element X is zirconium (Zr), the content of the element X is preferably 100 ppm or more and 1,000 ppm or less expressed in terms of atoms.

When the alumina raw material of the present invention contains only one element X and the element X is tantalum (Ta), the content of the element X is preferably 100 ppm or more and 1,000 ppm or less expressed in terms of atoms.

The alumina raw material of the present invention can be produced by heat-melting, as raw materials, a predetermined amount of solid-state alumina and a compound containing an element X in an appropriate container such as a crucible, and cooling the thus obtained melt.

There is no particular limitation on the compound containing an element X, and an oxide is usually used so as to avoid mixing of impurity elements other than an oxygen atom as much as possible.

In the alumina raw material of the present invention, the concentration of alumina in components excluding an element X, silicon (Si), gallium (Ga), germanium (Ge) and tin (Sn) is 99.99% by weight or more.

The concentration of alumina can be determined by solid-state emission spectroscopy. As shown in the following equation (1), the concentration of alumina can be determined by determining each concentration of Na, Mg, Cu, Fe and Ca in alumina using solid-state emission spectroscopy, and subtracting the obtained sum total of the concentrations of the respective elements from 100.

$$\text{Concentration of alumina} = 100 - [\text{sum total of concentrations of Na} + \text{Mg} + \text{Cu} + \text{Fe} + \text{Ca}] \, (\%) \qquad (1)$$

When the concentration of alumina is less than 99.99% by weight, crystallinity may excessively deteriorate to cause too large distortion of a sapphire single crystal.

In order to achieve the above-mentioned concentration of alumina, alumina having the concentration of 99.99% by weight or more may be used as alumina before mixing and melting with the element X.

Here, the concentration of alumina can be determined by solid-state emission spectroscopy. The concentration of alumina can be determined by determining each concentration of Na, Mg, Cu, Fe and Ca in alumina through solid-state emission spectroscopy, and subtracting the sum total of the concentrations of the respective elements from 100.

The alumina raw material of the present invention preferably has a specific surface area of 0.1 $m^2$/g or more and 2.0 $m^2$/g or less, and more preferably 0.2 $m^2$/g or more and 1.0 $m^2$/g or less. It is preferred that the alumina raw material of the present invention has a relative density of 80% to 95%, and a closed porosity of 4% or less. Furthermore, the alumina raw material of the present invention has an untamped density (loose bulk density) of 1.0 g/$cm^3$ or more, preferably 1.5 g/$cm^3$ or more, and more preferably 2.0 g/$cm^3$ or more.

The alumina raw material having such physical properties is suited as a raw material of a pulling and growing method of a sapphire single crystal ingot since it contains less moisture incorporated into closed pores in the production process, and thus the moisture may not cause oxidation of a crucible when heat-melted.

Specific methods for the measurement of specific surface area, relative density, closed porosity, and untamped density are as follows.

The specific surface area is measured by a nitrogen adsorption method using a BET specific surface area analyzer [for example, "2300-PC-1A" manufactured by Shimadzu Corporation].

The relative density is calculated by the following equation after measuring the sintered density using an Archimedean method.

$$\text{Relative density (\%)} = \text{sintered density } [\text{g/cm}^3]/3.98$$

$$[\text{g/cm}^3; \ \alpha \text{ alumina theoretical sintered density}] \times 100$$

The closed porosity is calculated from the particle density and the pore volume (open pore volume) by the following equations. The pore volume is determined as the pore volume at the pore radius within a range of 1 μm or less by a mercury penetration method after drying a sample at 120°C for 4 hours. The particle density is calculated based on the method for the measurement of the true specific density defined in JIS R7222 (1997).

$$\text{Closed pore volume (cm}^3/\text{g)} = (1/\text{particle density}) -$$

$$(1/3.98)$$

$$\text{closed porosity (\%)} = [(\text{closed pore volume})/\{(1/3.98) +$$

$$\text{pore volume} + \text{closed pore volume}\}] \times 100$$

The untamped density is calculated from the weight and the volume of a sample after filling a prescribed container with the sample based on JIS R9301-2-3 (1999).
The shape of the alumina raw material of the present invention may be any shape such as powder, granule, pellet, disk, block and the like, and is usually powder.

<2. Method for Producing Sapphire Single Crystal>

The method for producing a sapphire single crystal of the present invention will be described below.
A first embodiment of the method for producing a sapphire single crystal of the present invention includes the steps of:

using, as raw materials, the above-mentioned alumina raw material of the present invention, charging the alumina raw material in a crucible disposed in a furnace body, and heating to melt the alumina raw material, and
pulling a sapphire single crystal ingot from a melt obtained as a result of melting of the alumina raw material to grow the sapphire single crystal ingot in an inert gas atmosphere.

As mentioned above, use of the alumina raw material of the present invention as a raw material enables little incorporation of the element X into a sapphire single crystal obtained by a pulling method. Therefore, it is possible to obtain a sapphire single crystal with less crystal distortion and little content of impurities.
In a second embodiment of the method for producing a sapphire single crystal of the present invention, a raw compound containing alumina and an element X may be used in place of the alumina raw material of the present invention so that the melt after heat-melting has the same composition as that of the melt of the alumina raw material of the present invention.
In other words, the second embodiment of the method for producing a sapphire single crystal of the present invention includes the steps of:

charging, as raw materials, alumina in which each content of silicon (Si), gallium (Ga), germanium (Ge) and tin (Sn) is 10 ppm or less expressed in terms of atoms and a compound containing at least one element X selected from the group consisting of elements (1) to (3) mentioned below in a crucible disposed in a furnace body so that the concentration of the element X becomes 10 ppm or more and 1,000 ppm or less expressed in terms of atoms based on alumina, and heating to melt the raw materials, and
pulling a sapphire single crystal ingot from a melt obtained as a result of melting of the raw materials to grow the sapphire single crystal ingot in an inert gas atmosphere. Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

It is also possible to obtain a sapphire single crystal with less crystal distortion and little content of impurities by the production method of the second embodiment, in the same manner as in the production method of the first embodiment.

Hereinafter, production methods of the first and second embodiments may be sometimes collectively called a "method for producing a sapphire single crystal of the present invention".

The method for producing a sapphire single crystal of the present invention enables the production using a conventionally known single crystal pulling apparatus for the production of sapphire. It is possible to use, for example, an apparatus disclosed in Patent Document 1.

The step of heat-melting raw materials, and the step of pulling and growing an ingot in the first embodiment of the method for producing a sapphire single crystal of the present invention will be described in detail below.

(Step of Heat-Melting Raw Materials)

In the case of producing a sapphire ingot, first, the above-mentioned alumina raw material for the production of a sapphire single crystal of the present invention is charged in a crucible.

Then, the alumina raw material of the present invention, which is the raw material in the crucible, is melted by heating to obtain an alumina melt.

In the second embodiment, a raw compound containing alumina and an element X may be used, as raw materials, in place of the alumina raw material of the present invention so that the composition becomes the same as that of the alumina raw material of the present invention.

It is possible to use, as a furnace used for heating, conventionally known heating furnaces such as a resistance furnace and a high frequency induction heating furnace. Non-uniform heating of the alumina melt by a heating furnace may cause a problem that quality of a sapphire single crystal growth from an alumina melt deteriorates due to convection of the alumina melt. Generally, heat is uniformly spread over the entire resistance furnace, and thus convection of the alumina melt is less likely to occur. However, the melt made of the alumina raw material of the present invention (or a raw compound containing alumina and an element X) is capable of growing a high-quality sapphire single crystal even when using a high frequency induction heating furnace which is likely to cause non-uniform heating.

The heating conditions are the temperature and time required to convert the raw materials into a melt, and the melting temperature and time slightly vary depending on the kind of the element X included. Usually, heating is performed at 2,000°C or higher and 2,050°C or lower for 10 hours or more, and preferably at 2,000°C or higher and 2,050°C or lower for 15 hours or more.

The atmosphere, under which raw materials are heat-melted, is not particularly limited, and is usually an inert gas atmosphere. As used herein, an inert gas means a nonreactive gas such as helium, argon or nitrogen.

(Step of Pulling and Growing Ingot)

The present step is the step of pulling a sapphire single crystal ingot from an alumina melt, which is obtained in the step of heat-melting the above-mentioned raw materials, to grow the sapphire single crystal ingot.

The atmosphere in the step of pulling and growing the ingot is indispensably an inert gas atmosphere, and the concentration of oxygen in a furnace body is preferably within a range of 0.2 to 1.0% by volume, and more preferably 0.3 to 0.8% by volume. When the concentration of oxygen is less than 0.2% by volume, subgrains are likely to be generated in the crystal due to formation of $Al_2O_{3-x}$. When the concentration of oxygen exceeds 1.0% by volume, oxidation of a crucible material proceeds to accelerate deterioration of the crucible, and thus metal oxide generated from the crucible material is likely to scatter in the furnace, leading to mixing in the melt. As a result, the crucible material is incorporated into the crystal and thus defects such as coloration are likely to occur.

In the step of pulling and growing an ingot, first, the alumina melt obtained in the step of heat-melting the raw materials is brought into contact with the lower end of the seed crystal. At this time, the temperature is usually 1,950°C to 2,050°C.

Then, the seed crystal in contact with the alumina melt is pulled upward while rotating to form the shoulder of the seed crystal below the seed crystal. Subsequently, the shoulder is pulled upward while rotating via the seed crystal to form a straight barrel below the shoulder. Subsequently, the straight barrel is pulled upward while rotating via the seed crystal and the shoulder, thereby separating from the alumina melt to form the tail below the straight barrel.

Then, the obtained sapphire single crystal ingot is taken out from the chamber after cooling.

In the obtained sapphire single crystal ingot, the shoulder usually has a shape in which the diameter gradually expands toward the straight barrel side from the seed crystal side. The straight barrel has a shape in which the diameter becomes almost the same toward a downward direction from an upward direction. The diameter of the straight barrel is set at the value which is slightly larger than that of a wafer of the previously designed sapphire single crystal.

The tail has a shape (convex shape) in which the diameter gradually reduces toward a downward direction from an upward direction to form a protrusion toward a downward direction from an upward direction.

Crystallinity (magnitude of distortion) of the sapphire single crystal ingot can be evaluated from a state where polarized light is transmitted (smoothness of an interference line of a cross-Nicol image) using a sapphire single crystal substrate obtained by slicing at near the center of the ingot.

Details of the evaluation method will be described in Examples.

In the method for producing a sapphire single crystal of the present invention, a sapphire single crystal is preferably pulled and grown in a c-axis direction.

Since a single crystal of sapphire grows in a c-axis direction toward the downward tail side from the upward seed crystal side by pulling and growing, it is possible to obtain a c-plane substrate suited for a substrate for GaN growth for the production of LED by slicing along a plane perpendicular to a c-axis.

In the method for producing a sapphire single crystal of the present invention, it is preferred that the sapphire single crystal ingot thus taken out from the chamber is subjected to a heat treatment to reduce distortion generated by temperature distribution inside the ingot during crystal growth.

Then, the straight barrel having the same diameter toward a downward direction from an upward direction is cut out from the sapphire single crystal ingot thus obtained, and the straight barrel thus cut out is cut into a sapphire single crystal substrate having a thickness of about 0.5 to 2 mm by cutting means such as a multiwire saw.

Then, the substrate surface was lapped and polished to obtain a sapphire single crystal substrate whose surface is subjected to mirror finish processing. Since the crystal grows in a c-axis direction of the sapphire single crystal, a principal plane of the obtained substrate corresponds to a c-plane ((0001) plane) of the sapphire single crystal.

The principal plane of the substrate may be used as a c-plane, or an off-angled c-plane may be used as a processed plane. It is also possible to cut out on the plane other than the c-plane. The surface of the substrate thus cut out may be smoothened or roughened.

<Sapphire Single Crystal>

The sapphire single crystal of the present invention is produced by the method mentioned above using, as a raw material, an alumina raw material containing an element X of the present invention, or a raw compound containing alumina and an element X, the composition of which becomes the same as that of the alumina raw material of the present invention when it is in a molten state. In the sapphire single crystal of the present invention, the concentration of the element X is 5 ppm or less, and preferably 3 ppm or less, expressed in terms of atoms.

The sapphire single crystal of the present invention can be suitably used for applications such as a substrate for growth of a compound semiconductor, and a polarizer supporting substrate because of low concentration of impurities in the crystal as mentioned above.

The shape of the sapphire single crystal of the present invention is not particularly limited and includes any shape such as a sapphire ingot after pulling and growing, and a sapphire substrate obtained by slicing the ingot.

The application method of the sapphire single crystal of the present invention is not particularly limited, and the sapphire single crystal is suitably used as a sapphire substrate in a light emitting device, an optical device, a projector, and the like.

Examples

The present invention will be described in more detail below by way of Examples, but the present invention is not limited to the following Examples without departing from the scope of the invention.

1. Production of Alumina Raw Material for Production of Sapphire Single Crystal and Sapphire Ingot

Example 1

(1) Production of Alumina Raw Material for Production of Sapphire Single Crystal

In a crucible having a diameter of $\varphi$50 mm made of iridium, 235 g a high-purity alumina raw material and 0.016 g (B: corresponding to 100 ppm) of a boron raw compound ($B_2O_3$) as an additive were respectively charged. The alumina raw material and the boron raw compound were melted by gradually raising the temperature to 2,050°C under a $N_2$ atmosphere, followed by cooling to obtain an alumina raw material of Example 1.

(2) Production of Sapphire Ingot

Using a single crystal pulling apparatus, a sapphire ingot for evaluation was produced. A schematic diagram of the single crystal pulling apparatus is shown in Fig. 1. A high-frequency induction furnace 1 was used as a heating furnace and a crucible 2 having a diameter of $\varphi$50 mm made of iridium was used as a crucible.

In the high-frequency induction furnace 1, the crucible 2 made of iridium is accommodated in a heat insulated container 3. The heat insulated container 3 is surrounded by a heating section 4 (heating coil) and the heating section 4 is connected to a coil power supply 5. The heat insulated container 3 is connected to a gas supply section 6 and an exhaust section 7, thus enabling replacement of the atmosphere in the heat insulated container 3 by a $N_2$ atmosphere.

First, the obtained alumina raw material of Example 1 was charged in the crucible 2 made of iridium and melted at 2,050°C under a $N_2$ atmosphere. Thereafter, an alumina single crystal cut out in a c-axis direction was used as a seed crystal 8 and the seed crystal 8 was allowed to descend near to an alumina melt 9. This seed crystal 8 was allowed to gradually descend while rotating at 5 to 15 rpm and tip of the seed crystal 8 was brought into contact with the melt 9, followed by starting of crystal pulling at a pulling speed of 0.5 to 2 mm/h while gradually decreasing the temperature, using a pulling bar 10. The pulling bar 10 is connected to a weight detection section 11, a pulling drive section 12 and a rotary drive section 13. The coil power supply 5, the gas supply section 6, the exhaust section 7, the weight detection section 11, the pulling bar 12 and the rotary drive section 13 are respectively connected to a control section 14. Therefore, it is possible to pull a sapphire ingot while precisely controlling the temperature. While precisely controlling the temperature, a straight barrel of a sapphire ingot having a diameter of about 25 mm was formed, thus producing a sapphire ingot having a length of about 100 mm including the tail.

The additive element X in Example 1 and the concentration of X in the raw material are shown in Table 1.

Examples 2 and 3

(1) Production of Alumina Raw Material for Production of Sapphire Single Crystal

In the same manner as in Example 1, except that, regarding raw materials to be charged in a crucible first, the amount of a boron raw compound ($B_2O_3$) to be added was respectively changed to 0.032 g (Example 2, B: corresponding to 200 ppm) and 0.064 g (Example 3, B: corresponding to 400 ppm) based on 235 g of a high-purity alumina raw material, alumina raw materials of Examples 2 and 3 were obtained.

(2) Production of Sapphire Single Crystal

In the same manner as in Example 1, except that alumina raw materials of Examples 2 and 3 were respectively used in place of the alumina raw material of Example 1, sapphire ingots of Examples 2 and 3 were obtained.

The additive element X in Examples 2 and 3 and the concentration of X in the raw material are shown in Table 1.

Examples 4 to 6

(1) Production of Alumina Raw Material for Production of Sapphire Single Crystal

In the same manner as in Example 1, except that a selenium raw compound was used as an additive in raw materials to be charged in a crucible first, and the amount of the selenium raw compound ($SeO_2$ was respectively changed to 0.026 g (Example 4, Se: corresponding to 100 ppm), 0.051 g (Example 5, Se: corresponding to 200 ppm), and 0.102 g (Example 6, Se: corresponding to 400 ppm), based on 235 g of a high-purity alumina raw material, alumina raw materials of Examples 4 to 6 were obtained.

(2) Production of Sapphire Ingot

In the same manner as in Example 1, except that alumina raw materials of Examples 4 to 6 were used in place of the alumina raw material of Example 1, sapphire ingots of Examples 4 to 6 were obtained.

The additive element X in Examples 4 to 6 and the concentration of X in the raw material are shown in Table 1.

Examples 7 to 9

(1) Production of Alumina Raw Material for Production of Sapphire Single Crystal

In the same manner as in Example 1, except that a zirconium raw compound was used as an additive in raw materials to be charged in a crucible first, and the amount of the zirconium raw compound ($ZrO_2$) was respectively changed to 0.028 g (Example 7, Zr: corresponding to 100 ppm), 0.057 g (Example 8, Zr: corresponding to 200 ppm), and 0.114 g (Example 9, Zr: corresponding to 400 ppm), based on 235 g of a high-purity alumina raw material, alumina raw materials of Examples 7 to 9 were obtained.

(2) Production of Sapphire Ingot

In the same manner as in Example 1, except that alumina raw materials of Examples 7 to 9 were respectively used in place of the alumina raw material of Example 1, sapphire ingots of Examples 7 to 9 were obtained.
The additive element X in Examples 7 to 9 and the concentration of X in the raw material are shown in Table 1.

Examples 10 to 12

(1) Production of Alumina Raw Material for Production of Sapphire Single Crystal

In the same manner as in Example 1, except that a tantalum raw compound was used as an additive in raw materials to be charged in a crucible first, and the amount of the tantalum raw compound ($Ta_2O_5$) was respectively changed to 0.102 g (Example 10, Ta: corresponding to 100 ppm), 0.204 g (Example 11, Ta: corresponding to 200 ppm), and 0.407 g (Example 12, Ta: corresponding to 400 ppm), based on 235 g of a high-purity alumina raw material, alumina raw materials of Examples 10 to 12 were obtained.

(2) Production of Sapphire Ingot

In the same manner as in Example 1, except that alumina raw materials of Examples 10 to 12 were respectively used in place of the alumina raw material of Example 1, sapphire ingots of Examples 10 to 12 were obtained.
The additive element X in Examples 10 to 12 and the concentration of X in the raw material are shown in Table 1.

Comparative Example 1

(1) Production of Sapphire Ingot

In the same manner as in Example 1, except that only 235 g of a high-purity alumina raw material was used and no additive was added in raw materials to be charged in a crucible first, a sapphire ingot of Comparative Example 1 was obtained.

Comparative Examples 2 to 4

(1) Production of Alumina Raw Material for Production of Sapphire Single Crystal

In the same manner as in Example 1, except that a gallium raw compound was used as an additive in raw materials to be charged in a crucible first, and the amount of the gallium raw compound ($Ga_2O_3$) was respectively changed to 0.043 g (Comparative Example 2, Ga: corresponding to 100 ppm), 0.086 g (Comparative Example 3, Ga: corresponding to 200 ppm), and 0.173 g (Comparative Example 4, Ga: corresponding to 400 ppm), based on 235 g of a high-purity alumina raw material, alumina raw materials of Comparative Examples 2 to 4 were obtained.

(2) Production of Sapphire Ingot

In the same manner as in Example 1, except that alumina raw materials of Comparative Examples 2 to 4 were respectively used in place of the alumina raw material of Example 1, sapphire ingots of Comparative Examples 2 to 4 were obtained.
The additive element X in Comparative Examples 2 to 4 and the concentration of X in the raw material are shown in Table 1.

2. Evaluation of Sapphire Ingot

2.1. Evaluation of Crystallinity of Sapphire Ingot

Each of sapphire ingots obtained by the procedures shown respectively in Examples 1 to 12 and Comparative Examples 1 to 4 was cut at the center using a hand saw and a cut surface was polished, and then distortion inside the crystal was evaluated by smoothness of an interference line of a cross-Nicol image in a c-plane.
The results are collectively shown in Table 1. Evaluation criteria in Table 1 are as follows.

A: Smooth interference line is observed.
B: Mostly smooth interference line is observed, but non-smooth portions partially exist.
C: An interference line is observed, but is not smooth.
D: No interference line is observed.

In all Examples 1 to 12, an improvement in crystal quality was recognized as compared with Comparative Example 1 as a result of the observation of distortion (C to A). To the contrary, in Comparative Example 2, due to incorporation of the additive element into the crystal, distortion occurred inside the crystal, thus failing to observe an interference line, resulting in rating of failing.

2.2. Evaluation of Amount of Impurities in Sapphire Ingot

With respect to sapphire ingots obtained by the procedures shown respectively in Examples 1 to 12 and Comparative Examples 1 to 4, impurities existing inside were evaluated using an ICP atomic emission spectroscopic method.
The results are collectively shown in Table 1.
First, the concentration of the additive in raw materials was respectively 100, 200 and 400 ppm in Examples 1 to 3 in which boron (B) is contained as the element X, while the concentration of the element X (B) in the obtained crystal was 3 ppm or less in all Examples.
These results reveal that boron (B) is hardly incorporated into the sapphire crystal.
The concentration of the additive in raw materials was respectively 100, 200 and 400 ppm in Examples 4 to 6 in which selenium (Se) is contained as the element X, while the concentration of the element X (Se) in the obtained crystal was 2 ppm or less in all Examples.
These results reveal that selenium (Se) is hardly contained in the sapphire crystal.
The concentration of the additive in raw materials was respectively 100, 200 and 400 ppm in Examples 7 to 9 in which zirconium (Zr) is contained as the element X, while the concentration of the element X (Zr) in the obtained crystal was respectively 1 ppm or less, 2 ppm, and 2 ppm.
These results reveal that zirconium (Zr) is hardly contained in the sapphire crystal.
The concentration of the additive in raw materials was respectively 100, 200 and 400 ppm in Examples 10 to 12 in which tantalum (Ta) is contained as the element X, while the concentration of the element X (Ta) in the obtained crystal was 2 ppm or less in all Examples.
These results reveal that tantalum (Ta) is hardly contained in the sapphire crystal.
In Comparative Examples 2 to 4 in which gallium (Ga) is contained as an additive, since the concentration of the additive in raw materials became high concentration such as 22 ppm, 31 ppm and 110 ppm, compressive stress was generated in the obtained crystal, leading to an increase in crystal distortion, thus failing to observe an interference line.
In Comparative Example 1 in which no additive is added, the concentration of the additive in raw materials is detection limit or less, and the concentrations of all impurities (each concentration of B, Se, Zr, Ta, and Ga was measured) in the obtained crystal was detection limit or less.

Table 1

| | Additive element X | Concentration X in raw material (ppm) | Concentration of additive in crystal (ppm) | Evaluation of cross-Nicol image |
| --- | --- | --- | --- | --- |
| Example 1 | B | 100 | ≤ 3 | B |
| Example 2 | B | 200 | ≤ 3 | C |
| Example 3 | B | 400 | ≤ 3 | C |
| Example 4 | Se | 100 | ≤ 2 | B |
| Example 5 | Se | 200 | ≤ 2 | B |
| Example 6 | Se | 400 | ≤ 2 | A |
| Example 7 | Zr | 100 | ≤ 1 | B |
| Example 8 | Zr | 200 | 2 | B |
| Example 9 | Zr | 400 | 2 | B |

(continued)

|  | Additive element X | Concentration X in raw material (ppm) | Concentration of additive in crystal (ppm) | Evaluation of cross-Nicol image |
|---|---|---|---|---|
| Example 10 | Ta | 100 | ≤ 2 | B |
| Example 11 | Ta | 200 | ≤ 2 | B |
| Example 12 | Ta | 400 | ≤ 2 | A |
| Comparative Example 1 | None | - | Detection limit or less | D |
| Comparative Example 2 | Ga | 100 | 22 | D |
| Comparative Example 3 | Ga | 200 | 31 | D |
| Comparative Example 4 | Ga | 400 | 110 | D |

Industrial Applicability

The alumina raw material of the present invention is suited as raw materials for the production of a sapphire single crystal ingot. In a pulling and growing method of a sapphire single crystal ingot, such as a Czochraski method, use of the alumina raw material of the present invention enables production of a sapphire single crystal ingot with less distortion. A sapphire single crystal obtained by processing the obtained sapphire single crystal ingot has less crystal distortion and contains little impurities. Therefore, the sapphire single crystal can be suitably used in various applications such as a light emitting device.

Description of Reference Symbols

1: High-frequency induction furnace
2: Crucible
3: Heat insulated container
4: Heating section
5: Coil power supply
6: Gas supply section
7: Exhaust section
8: Seed crystal
9: Melt
10: Pulling bar
11: Weight detection section
12: Pulling drive section
13: Rotary drive section
14: Control section

Claims

1. An alumina raw material for the production of a sapphire single crystal, comprising:

at least one element X selected from the group consisting of elements (1) to (3) mentioned below, wherein the concentration of the element X is 10 ppm or more and 1,000 ppm or less expressed in terms of atoms, and each concentration of silicon (Si), gallium (Ga), germanium (Ge), and tin (Sn) is 10 ppm or less expressed in terms of atoms.

Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

2. The alumina raw material according to claim 1, comprising , as the element X, at least one element selected from the group consisting of boron (B), selenium (Se), zirconium (Zr), and tantalum (Ta).

3. The alumina raw material according to claim 1 or 2, wherein the concentration of alumina is 99.99% by weight or more in components excluding the element X, silicon (Si), gallium (Ga), germanium (Ge) and tin (Sn).

4. The alumina raw material according to claim 1, wherein a specific surface area is 0.1 $m^2$/g or more and 2.0 $m^2$/g or less, a relative density is 80% or more and 95% or less, a closed porosity is 4% or less, and an untamped density is 1.0 g/$cm^3$ or more.

5. A method for producing a sapphire single crystal, comprising the steps of:

charging the alumina raw material according to claim 1 in a crucible disposed in a furnace body and heating to melt the alumina raw material, and
pulling a sapphire single crystal ingot from a melt obtained as a result of melting of the alumina raw material to grow the sapphire single crystal ingot in an inert gas atmosphere.

6. A method for producing a sapphire single crystal, comprising the steps of:

charging, as raw materials, alumina and a compound containing at least one element X selected from the group consisting of elements (1) to (3) mentioned below in a crucible disposed in a furnace body in the proportion so that the concentration of the element X becomes 10 ppm or more and 1,000 ppm or less expressed in terms of atoms, and each concentration of silicon (Si), gallium (Ga), germanium (Ge), and tin (Sn) becomes 10 ppm or less expressed in terms of atoms, the concentration being based on alumina, and heating to melt the raw materials, and
pulling a sapphire single crystal ingot from a melt obtained as a result of melting of the raw materials to grow the sapphire single crystal ingot in an inert gas atmosphere.
Element X:

(1) Element having an ionic radius of 0.3 Å or less, and a valence of 3
(2) Element having an ionic radius of 0.4 Å or more and 0.5 Å or less, and a valence of 4
(3) Element having an ionic radius of 0.6 Å or more and 0.7 Å or less, and a valence of 4 or 5

7. The method for producing a sapphire single crystal according to claim 6, wherein the element X is at least one element selected from the group consisting of boron (B), selenium (Se), zirconium (Zr), and tantalum (Ta).

8. The method for producing a sapphire single crystal according to claim 6 or 7, wherein the concentration of alumina is 99.99% by weight or more.

9. The method for producing a sapphire single crystal according to claim 5, wherein the sapphire single crystal is pulled and grown in a c-axis direction.

10. A sapphire single crystal produced by the method according to claim 5, wherein the concentration of the element X is 5 ppm or less expressed in terms of atoms.

[Fig. 1]

## INTERNATIONAL SEARCH REPORT

International application No.

PCT/JP2013/064966

### A. CLASSIFICATION OF SUBJECT MATTER
C30B29/20(2006.01)i, C30B15/02(2006.01)i

According to International Patent Classification (IPC) or to both national classification and IPC

### B. FIELDS SEARCHED

Minimum documentation searched (classification system followed by classification symbols)
C30B29/20, C30B15/02

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)
JSTPlus(JDreamIII), CAplus(STN)

### C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2011/065403 A1 (Showa Denko Kabushiki Kaisha),<br>03 June 2011 (03.06.2011),<br>paragraphs [0036] to [0041], [0057]<br>(Family: none) | 1,5,6,9,10<br>3,4,8<br>2,7 |
| X | JP 2008-266078 A (Shin-Etsu Chemical Co., Ltd.),<br>06 November 2008 (06.11.2008),<br>paragraphs [0036] to [0038]<br>(Family: none) | 10 |
| Y | JP 2008-100903 A (Sumitomo Chemical Co., Ltd.),<br>01 May 2008 (01.05.2008),<br>paragraphs [0001], [0038] to [0040]<br>& US 2010/0040535 A1    & EP 2070873 A1 | 3,4,8 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>02 July, 2013 (02.07.13) | Date of mailing of the international search report<br>16 July, 2013 (16.07.13) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2013/064966 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 7-206432 A   (Sumitomo Chemical Co., Ltd.),<br>08 August 1995 (08.08.1995),<br>entire text<br>& US 6106800 A           & EP 0680929 A1 | 1-10 |
| A | JP 2009-067673 A  (Osram Sylvania Inc.),<br>02 April 2009 (02.04.2009),<br>entire text<br>& US 2009/0069168 A1     & EP 2037010 A1 | 1-10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012012242 A